# EUROPEAN PATENT APPLICATION

(11) **EP 4 712 508 A1**
(43) Date of publication of application: **18.03.2026**
(21) Application number: 25200984.0
(22) Date of filing: 09.09.2025
(51) Int. Cl.: H04R 1/10, H04R 3/04, H04R 29/00

(54) **A SYSTEM COMPRISING A PASSIVE HEADPHONE AND AN AUDIO CONTROLLER, AND A METHOD FOR CALIBRATING A PASSIVE HEADPHONE**

(30) Priority: 13.09.2024 FI 20246123
(71) Applicant: Genelec OY, 74100 Iisalmi (FI)
(72) Inventor: MÄKIVIRTA, Aki, 74100 Iisalmi (FI); TIKKANEN, Jussi, 74100 Iisalmi (FI); KOPONEN, Marko, 74100 Iisalmi (FI); RISSANEN, Ilkka, 74100 Iisalmi (FI); NORJA, Sauli, 74100 Iisalmi (FI); NAGHIAN, Siamäk, 74100 Iisalmi (FI)
(74) Representative: Laine IP Oy

(57) **Abstract**

There is provided a system comprising a passive headphone (101) and an audio controller (102), where the passive headphone (101) is connected to the audio controller (102). The audio controller (102) is configured to get factory calibration data, which is specific for the passive headphone (101) and associated to an identifier of the passive headphone (101), and the audio controller (102) is configured to apply the factory calibration data to an electrical signal inputted to the passive headphone (101).

## Description

### TECHNICAL FIELD

The present invention relates to a system comprising a passive headphone and an audio controller, and a method for calibrating a passive headphone.

### BACKGROUND

A passive headphone lacks an amplifier and a power source (battery) needed to drive transducers of a headphone to generate audio output. A passive headphone is therefore connected to an audio controller, which comprises a headphone amplifier and the power source components. The audio controller is configured to pass electrical signals to the passive headphone, where those are output as sound.

### SUMMARY

Aim is to provide a factory calibration for passive headphones.

The invention is defined by the features of the independent claims. Some embodiments are defined in the dependent claims.

According to a first aspect of the present invention, there is provided a system comprising a passive headphone and an audio controller, where the passive headphone is connected to the audio controller. The audio controller is configured to get factory calibration data, which is specific for the passive headphone and associated to an identifier of the passive headphone, and the audio controller is configured to apply the factory calibration data to an electrical signal inputted to the passive headphone.

The identifier may be dedicated to the passive headphone; and/or the identifier is a serial number, a component, a memory chip, a transponder, an electronic tag, or a radio frequency identification, RFID, tag. The identifier may be attached to the passive headphone, associated with the passive headphone, and/or available in or with the passive headphone.

The audio controller may comprise an integrated headphone amplifier and the headphone comprises one or more transducers, wherein the headphone amplifier is configured to amplify the electrical signal transmitted to the one or more transducers of the passive headphone configured to reproduce the electrical signal to a sound output.

The factory calibration data has been pre-stored to the audio controller paired with the passive headphone, and to a remote storage. The factory calibration comprises at least one of the following parameters measured for both sides of the passive headphone: impedance, sensitivity, level and phase of acoustic output in response to an electrical input, optionally for all frequencies. The factory calibration of the passive headphone, applied by the audio controller, is configured to adjust a frequency response of the passive headphone.

The system according to the first aspect may further comprise a computer configured to be connected to the audio controller, wherein the audio controller is configured to receive the factory calibration data from the computer, which is configured to access a remote storage, in order to receive the factory calibration saved to the remote storage, in response to provided identifier of the passive headphone. The computer may comprise at least a processor and a memory comprising instructions executable by the processor, and the computer may be configured to access a remote storage.

The identifier of the passive headphone may be received by the audio controller automatically, in response to being connected to the passive headphone, and/or via a short-range signalling from the passive headphone. The identifier of the passive headphone may be inputted to the computer, received by the computer, received via a short-range signalling by the computer, and/or received from the audio controller by the computer.

Information on a side of the passive headphone, to which the audio controller is connected to, is received by the audio controller automatically, upon connecting the passive headphone to the audio controller, via a connection cable of the passive headphone and the audio controller, and/or via short-range signalling. The audio controller may be connected to the passive headphone via a wired connection; and/or the audio controller may be connected to the computer via a wired connection

According to a second aspect of the present invention, there is provided a method for calibrating a passive headphone, which is connected to an audio controller. The method comprises getting, by the audio controller, factory calibration data, which is specific for the passive headphone and associated to an identifier of the passive headphone; and applying, by the audio controller, the factory calibration data to an electrical signal inputted to the passive headphone.

According to a third aspect of the present invention, there is provided use of a system comprising a passive headphone and an audio controller according to the first aspect, for audio mixing.

According to a third aspect of the present invention, there is provided use of a system comprising a passive headphone and an audio controller according to the first aspect, for studio mixing.

### BRIEF DESCRIPTION OF THE DRAWINGS

In the following embodiments are discussed in more detail with reference to the attached drawings, of which:
Figure 1A illustrates, by way of an example, a system comprising a passive headphone and an audio controller.
Figures 1B and 1C illustrate, by way of an example, a system comprising a passive headphone, an audio controller and a computer.
Figure 2 illustrates, by way of an example, an audio controller.
Figure 3 illustrates, by way of an example, a computer.
Figure 4 illustrates, by way of an example, a method for calibrating a passive headphone.

Figures are presented as illustrative examples and embodiments may not be limited solely to the illustrated parts, but modifications may be made under the scope as defined in the claims. Figures that may not fully present the claimed invention, aim to provide better understanding on the context and relating technical field.

### DESCRIPTION OF EMBODIMENTS

There is provided system comprising a passive headphone and an audio controller, to which the passive headphone is connectable via a wired connection. The audio controller comprises an amplifier, which enables the connected passive headphone to output audio. The audio controller may be connected to a computer. The computer enables data transfer to the audio controller, and viewing and adjusting settings of the audio controller in order to adjust the audio output to the passive headphone. Factory calibration data have been measured for each passive headphone by a manufacturer. The measured factory calibration data has been associated to an identifier, for example a serial number attached or associated with the passive headphone, and the factory calibration data is saved, for example to a cloud service. The factory calibration data is accessible by using the identifier of the passive headphone. Each passive headphone has unique factory calibration data associated with the unique identifier of the passive headphone. The factory calibration may be fetched via the computer, when the passive headphone, which is connected to the audio controller, is taken into use or being used. The factory calibration data is used for the passive headphone by the audio controller in order to adjust a frequency response of the passive headphone. The audio controller performs signal processing configured to augment the frequency response of the passive headphone. Applying the unique factory calibration of the passive headphone has positive effects on the characteristics and performance of the passive headphone.

Audible sound is variation in air pressure at frequencies audible to humans at magnitudes exceeding the human hearing threshold. Audible sound includes frequencies from 20 Hz to 20 000 Hz. Sound level is measured in decibels of sound pressure, dB SPL (sound pressure level), defined as 20 times the 10-base logarithm of the pressure variation root mean square, RMS, value divided by the pressure threshold value for human hearing, which is agreed to have value of 20 micro-Pascals, µP. RMS refers to amount of continuous power an amplifier is able to output. Sound can be recorded, stored and played back as an electrical signal proportional to the instantaneous sound pressure. The electrical signal may be turned to a numerical representation. For example, the electrical signal is turned to a digital representation of sound by an analogue-to-digital converter. Such electrical signal may be processed by a signal processor. Audio signal refers to electrical representations of any sound, being typically music and speech. In the headphones, an electrical audio signal is converted into audible sound using transducers.

Factory calibration refers to data, for example settings for filters that are determined collectively or separately for the left and right sides of each individual passive headphone. Left and right sides refer to the left earcup containing the left ear transducers, and the right earcup containing the right ear transducers, correspondingly. Factory calibration enables a manufacturer to unify the manufactured passive headphones in order to render all headphones the same in terms of their acoustical characteristics, for example to set the sound character of a headphone neutral, i.e. subjectively uncoloured. The same may apply also between the left and right earcups, in which case the left side and the right side of the passive headphone will be acoustically similar. Thirdly, factory calibration may render the transduction efficiency, at least substantially, the same across passive headphones and passive headphone earcups, resulting in the conversion sensitivity in a passive headphone to the same, i.e. how large sound pressure is generated for a certain magnitude of an electronic drive. Therefore, factory calibration enables reduction or elimination of unwanted left-right balance variation across the frequency as well as render all passive headphones to present the same sound character, or to reduce these effects to inaudible level or to at least an acceptable tolerance.

A binaural headphone comprises one transducer system for each ear of a user. The transducer system may comprise one or more electro-acoustic transducers configured to reproduce audio as a sound. A headphone may be located in various ways in relation to the ear(s). Over-the-ear, i.e., circumaural, headphone is configured to rest on the head and completely surrounds an external ear (pinna) of a user. On-the-ear (supra-aural) headphone is configured to rest on the external ear (pinna) of a user. Over-the-concha (supraconcha) headphone is configured to rest on the concha area of an external ear of a user. In-ear (intraconcha) and insert headphone types are configured to deliver audio directly into an ear channel of a user. Resting on the head is typically cushioned in order to make listening comfortable. In addition, it may enable effective and repeatable sealing of the volume inside the headphone, to avoid variations in the headphone frequency response due to leakage of the pressure inside the headphone. Such variations in the headphone frequency response may otherwise be significant, reducing repeatability of the intended headphone frequency response.

An identifier comprises a unique, headphone-specific identifier of a passive headphone. The identifier may comprise a serial number of a passive headphone, or other identifier, such as an electronic tag, a radio frequency identification, RFID, tag, a memory chip, or a component integrated physically to the headphone, or any such unifier or transponder. An identifier may be attached to, associated with and/or made available in or with each passive headphone. The identifier enables unique identification of a specific headphone.

The factory calibration may be fetched based on the identifier associated with the factory calibration. At the factory, the factory calibration of a specific passive headphone is saved to the audio controller paired and shipped with it. In addition, the factory calibration may be stored to a server, to a computer, to a remote device, to an external memory, to a cloud-based service, or alike storage which is accessible, for example, by a computer. The factory calibration may be accessible wirelessly or using a cable connection to a communication network or internet, for example.

A passive headphone comprises one or more transducers, which are configured to create acoustic pressure in response to an electrical input. Electrical input comprises an audio signal. In addition, a passive headphone may comprise passive electronic components configured to enable connectivity and divide the electrical input into multiple transducers. A passive headphone lacks active amplifier components and power source components, which are configured to generate electrical drive, like voltage or current, in order to drive the transducers and generate the audio output. A passive headphone is configured to be connected to an audio controller, which comprises the active amplifier components and power source components. The audio controller is configured to transmit electrical input (audio signal) to the passive headphone using a wired connection. The audio controller may further comprise a signal processor, analogue-to-digital and/or digital-to-analogue converters. Since passive headphones do not comprise power sources or power generating amplifiers, running out of battery in the passive headphone is avoided. On the contrary, wireless active headphones, which contain a wireless audio interface, amplifier and power supply components, suffer from audio transfer delay, and may suffer from audio quality deterioration issues. The delay and audio quality change issues are typically created by the fact that the wireless audio signal interface must encode the audio signal into a format that can be effectively transmitted to the active headphone, frequently leading to audio resolution and fidelity changes, particularly considering that the electrical power for such processing, as well as for the amplification, must be supplied by the power supply components and (typically a rechargeable) battery built into the active headphone. Encoding and wirelessly transporting audio signal into the headphone requires time and causes delay to audio signals and output. The passive headphone without electric storage components or a battery, and having a cable connection to an amplifier of an audio controller, is able to avoid all these audio quality degradation and delay issues. For a passive headphone processing of audio data is handled in an external audio controller, and no delay-generating encoding of audio is needed.

Manufactured headphones typically have some variation between each other due to variations in components used in production. Variations during production may be caused by the manufacturing processes or the components, for example. By nature, mechanical sound reproduction systems, such as headphones, typically vary slightly in their frequency response. This may introduce unwanted variation in a sound colour rendering, as well as the sound balance as a function of frequency between the left and right side of the passive headphone. In order to avoid variations between the headphones, each passive headphone has been calibrated in the factory and possible variations are compensated by factory calibration. The factory calibration provides neutral sound for each headphone, the same sound character across all headphone units, and between the left and the right side of each headphone once the factory calibration is applied. Factory calibration measurements are done after headphone manufacture for each individual passive headphone side before the headphone is shipped. Left and right side of a passive headphone are separately measured. The measured factory calibration enables the frequency response of the passive headphone to be adjusted to a desired frequency response across all manufactured passive headphones. As it is then possible to render similar the left and right side of a headphone may be rendered similar, a monophonic sound image, represented by, at least substantially, the same audio in the left and right earcups, may be adjusted to correctly appear in the middle of the sound presentation for the listener, and frequency dependent variation of the centre image may be avoided.

Factory calibration settings are measured at the end of the headphone assembly process, and each passive headphone is measured. Both earcups or both sides of the headphone are measured. The measurements per an earcup may comprise impedance, sensitivity, level and phase of the acoustic output for all frequencies, especially for the midrange frequencies, which may be from 500 Hz to 6 kHz. The measurements may be compared to predetermined target values, which may be determined to yield the desired subjective sound colour and performance. This target may be a neutral uncoloured sensation of the sound output for the listener and correct presentation of the sound image location for given electrical inputs to the left and right ear transducer systems. For example, the sound colour may be adjusted to a shape which delivers neutral sound for a diffuse field sound colour reference loudspeaker arrangement, such as specified in IEC 60268-7 (International Electrotechnical Commission, 2010, and other versions) and/or ITU BS.708 (International Telecommunication Union, Broadcasting Service, approved 1990-06, and other versions). Yet another target is the free-field target, which relates to a listening condition with lack of acoustic reflections and only direct sound from the sound source. In alternative Harman Target Curve variations may be utilized as targets. Harman Target Curve may comprise a headphone target curve being an idealized frequency response that is expected to satisfy the expectations and preferences of the majority of listeners.

As the headphone eliminates the natural effects of the head, torso, and external ears, the headphone may apply settings configured to emulate such natural effects, collectively referred to as the Head-Related Transfer Function, HRTF. HRTF is known to be personal and specifical for each person. Once the personal HRTF has been determined, binaural processing may use the HRTF information in order to render audio for headphone listening such that the audio signal appears to reside outside of the head and appears to be located in specific directions from the listener. Factory calibration of headphones may yield such binaural audio processing more reliable and accurate.

Neutral sound refers to reproduced sound not having coloration throughout the audible frequency range. A headphone with a neutral sound character delivers subjectively an even, honest, true and/or pure representation of the original audio data. In other words, a truly neutral headphone reproduces every frequency of sound across the whole range of hearing subjectively in equal measure, with less than three decibels of subjective variation across the frequency range. For example, a neutral frequency response has a balanced bass, mid, and treble frequency ranges, where the bass range may be described as frequencies from 20 to 250 Hz, midrange from 250 Hz to 6 kHz, and treble from 4 to 20 kHz. On the contrary, a non-neutral headphone has regions of excessive or lacking responsiveness. Furthermore, as there may be differences between the left and right side of the headphone, there may be unwanted frequency dependent variations in the left-right balance of the audio presentation. A person mixing or mastering audio data may be aurally misguided by the regions of excessive or lacking responsiveness and an inaccurate frequency-dependent left-right balance.

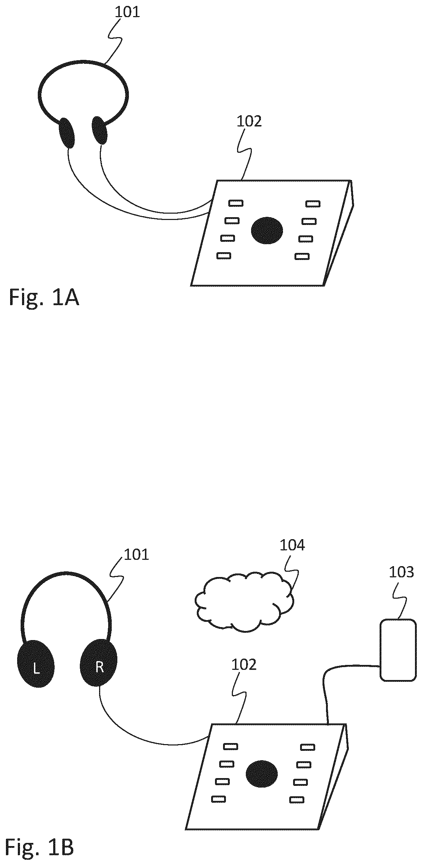

Figure 1A illustrates, by way of an example, a system comprising a passive headphone and an audio controller. The passive headphone 101 lacks electrical or power source components. The passive headphone 101 comprises one or more transducers configured to output sound. The passive headphone 101 is connected to an audio controller 102. The connection is a cable connection. In Fig. 1A there are connection cables for both sides of the earphone. In other examples, only one side of the headphone may be connected to the audio controller 102. The audio controller 102 comprises connection ports separately for the left and right sides of the headphone, as well as a single connection port, which is connectable to either of the sides of the headphone. The audio controller 102 comprises a memory, an amplifier, power source components, and an equipment and/or signal processing functions for amplifying, controlling, processing and setting the processing variables or parameters affecting the audio signals, which are passed to the passive headphone 101. Factory calibration data may be saved to a memory of the audio controller 102. The audio controller 102 is configured to process and to electrically drive input signal to the one or more transducers of the headphone 101, which are configured to generate audio output. Factory calibration data is applied to the electrical signal, which is inputted to the headphone 101.

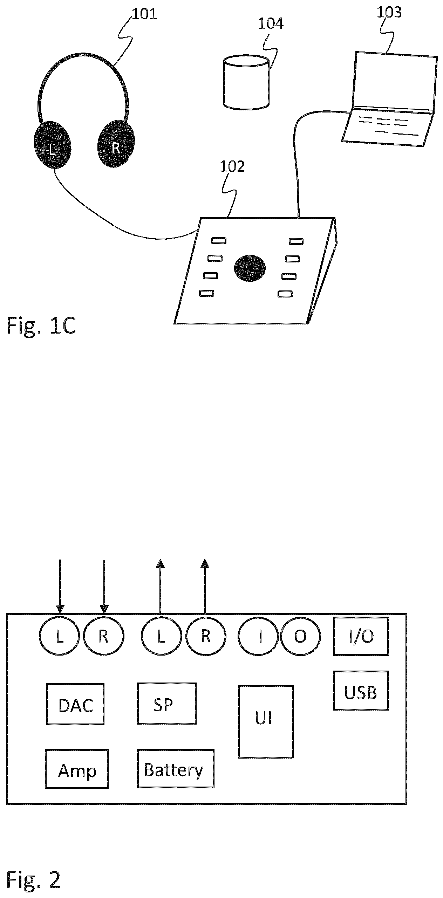

Figures 1B and 1C illustrates, by way of an example, a system comprising a passive headphone, an audio controller and a computer. The headphone 101 without electrical or processing components may be considered as a passive device. The passive headphone 101 is connected to the audio controller 102. Amplification processing and sound control is implemented in the audio controller 102, which is connected to the passive headphone 101. The audio controller 102 is further connected to a computer 103, which may be a desktop, a laptop or a smart phone. Connections may be wired connections. The computer 103 enables connections to internet, external terminals and/or storages 104. The computer 103 is able to fetch or receive pre-stored factory calibration settings from a remote storage 104 using an identifier, like a serial number or other unique identifier, placed in the passive headphone 101. The computer 103 transmits the settings to the audio controller 102, which uses the factor calibration settings to process signal(s) for the connected passive headphone 101. Output of the passive headphone 101 is always provided by the audio controller 102. The audio controller 102 comprises equipment or signal processing functions for amplifying, controlling, processing and setting the processing variables or parameters affecting the audio signals passed to the passive headphone 101. The computer 103 enables to deliver, download or stream audio data via the audio controller 102 to the headphone 101. The audio controller 102 may comprise inputs to enable audio signal to be directly delivered into the audio controller 102 to be processed and delivered to the headphone 101. The audio controller 102 enables adjusting the sound for the headphone101. When sound data is streamed via the computer 103, audio processing is done at the audio controller 102. This leaves the computer 103 also for other use without reserving a significant amount of its processing or bandwidth capacities. The signal processing function of the audio controller 102 may be executed remotely, for example in a cloud computation services, instead of a physical audio controller 102 connected to a headphone 101.

In Fig. 1A, the audio controller 102 amplifier output is connected to a right, R, earcup of the headphone 101.In Fig. 1B, the audio controller 102 amplifier output is connected to a left, L, earcup of the headphone 101. The passive headphone may comprise a connection port in both earcups. Thus, the user is able to connect a cable from the audio controller 102 to any one of the earcups of the headphone. This enables to provide improved ergonomics and to support the best connectivity in all usage scenarios. The factory calibration settings have been made separately for both earcups, left and right. The factory calibration may be made separately to all cases that cause the headphone frequency response to change, which may be due to change of cushioning materials and/or surface materials of the headphone. The earcups have been identified in order to separate the two earcups. The audio controller 102 is enabled to identify, or recognise and separate, the left, L, and right, R, sides of the headphone, i.e. earcups. Recognition may be automatic, or take place in response to a user input. The user may input information in order to describe the current configuration of the headphone 101. Recognition enables to select the correct factory calibrations for the left, L, and right, R, side of the headphone. The audio controller 102 is able to use the measured factory calibration settings for both the left, L, and right, R, earcups, correspondingly.

The passive headphone may be connected to the audio controller via universal serial bus, USB, cable, via an analogue audio cable known as an auxiliary, AUX, cable, via a high- definition multimedia interface, HDMI cable, via an optical or a coaxial cable, or example. When the passive headphone is connected to the audio controller, the audio controller may identify the passive headphone. An identifier of the passive headphone may be transferred to the audio controller via the connection. In addition, the audio controller may receive information on whether it is attached to the right or left side of the headphone. The information may be transferred from the headphone in response to connecting the headphone to the audio controller. Left and right side of the headphone may have identifiers, which is transferred in response to connection to the audio controller. In an alternative, the audio controller may request the information in response to connection of the headphone. The audio controller may receive an identifier of the headphone, in addition to information of the side of the connection of the headphone. The audio controller may have factory calibration data saved in its memory. The factory calibration data of the measured headphone may be saved after the factory calibration measurements in the factory, to the audio controller which is paired with the headphone. In response to receiving an identifier of the headphone paired to it, the audio controller is able to apply the factory calibration for the electric signal outputted to the headphone. In case a received identifier is not the one paired with the audio controller, the audio controller is able to receive the factory calibration via a computer in response to transmitting the identifier of the headphone to the computer. An identifier of a headphone may be attached to the headphone. The identifier and a side information may be read using radio frequency, or other short-range signalling, by the audio controller. For example, a passive RFID tag may be attached to the headphone and read by the audio controller comprising, or attached to, a reader device. In an embodiment, a user may input an identifier of the headphone, and optionally also a side information, to a computer. The computer has access to a data storage saving factory calibration data associated with a specific headphone identifier. The computer may receive factory calibration settings in response to transmitting the identifier to the data storage. The saved factory calibration comprises factory calibration information for both, left and right, sides of the headphone. The audio controller has information on the side of the headphone, it is connected to. The audio controller is able to apply factory calibration correctly to the both sides of the headphone.

A passive headphone may be changed or replaced to a new one, while the same audio controller is used. In such case, the new passive headphone is connected to the (already used) audio controller. Factory calibration settings of the new passive headphone are acquired using an identifier, like a serial number, of the new passive headphone. A computer receiving the factory calibration settings transmits those to the audio controller to be used in the signal processing for the new passive headphone. This way, a passive headphone is changeable and/or replaceable with individual factory calibration settings of each individual passive headphone, while the audio controller remains the same, and the resulting headphone sound character is enabled to remain the same, accurate and neutral. Also, multiple passive headphones may be used with a single audio controller, one headphone at a time. For example, in a work environment, a single audio controller may be utilized by several different passive headphones, and their users, at different times.

Figure 2 illustrates, by way of an example, an audio controller. The audio controller comprises input and output ports configured to input and output audio data, respectively. The audio controller may comprise input ports for left, L, and right, R, analogue audio data, and similarly output ports for left, L, and right, R, analogue audio data. The sound controller may comprise input and output, I/O, ports for digital audio data. The sound controller may comprise for example input/output, I/O, port for a headphone, a universal serial bus, USB, connection port, or other connection port, for example a cable, an AUX, a HDMI, a coaxial or alike ports. The audio controller comprises a battery, a user interface, UI, and a signal processor, SP. The audio controller comprises an amplifier, Amp, which may be a headphone amplifier integrated into the audio controller. The amplifier may amplify current, voltage or power. The amplifier, Amp, may be a power amplifier, which is configured to convert a low power signal to a high power one by increasing inputted power. A power amplifier may be called a large signal amplifier, which is configured to provide large amount of power to the input audio signal. A power amplifier enables providing more power to the output, while it tends to be larger and heavier compared to a non-power amplifier. However, size and weight are more of an issue for active headphones with integrated audio controller, while those have no effect on a size or weight of the passive headphones. In addition, the audio controller may comprise one or more transducers and a digital-to-analogue converter, DAC. The audio controller is configured to control audio data.

The audio controller may be a mobile or a portable audio controller. A mobile audio controller differs from a desktop audio controller in size: while a desktop audio controller is fixed in one place, like a studio, a mobile audio controller is portable, being smaller and lighter in weight compared to the desktop audio controller. A mobile audio controller may have limited number of functions and limited adjustment possibilities compared to the desktop version. A desktop audio controller is powered via mains through connected sockets, while a mobile audio controller may use batteries or AC power that can be recharged, in addition to operate using main power.

The audio controller may be connected to a passive headphone, for example via an I/O port. The audio controller may be connected to a computer via an USB port. Both connections may be wired, cable connections. Wired connections avoid lag or other issues dependent on a wireless network, which may be due to a place and/or a network used. The audio controller is configured to receive factory calibration settings, which have been measured and saved for the specific passive headphone. The factory calibration settings may be stored to the audio controller and/or received from the computer. The audio controller is configured to use the factory calibration settings for any input to the passive headphone.

Audio signals may be represented in either digital or analogue format, and audio signal processing may be based on either of those. Analog signal processors operate directly on the electrical signal, while digital signal processors operate mathematically on a digital representation of the electrical signal. An audio controller may be used for balancing and adjusting sound sources. The audio controller may comprise an equalizer, EQ, and/or a processor configured to process dynamics, audio effect, mixing, reproduction and reinforcement of sound. Equalization, EQ, comprises adjusting volume of different frequency bands within an audio signal. Audio filter may comprise a frequency dependent circuit, which may amplify (boost), pass, or attenuate (cut) selected frequencies or frequency ranges. Compression or a dynamic range compression, DRC, is configured to reduce volume of loud sounds or to amplify quiet sounds, thus reducing or compressing a dynamic range of an audio signal. Compression may be implemented by a compressor, which may be a dedicated electric hardware unit or an audio software.

The audio controller comprises equipment or signal processing functions for amplifying, controlling, processing and setting the processing variables or parameters affecting the audio signals passed to the passive headphone. The computer enables to deliver, download or stream audio data via the audio controller to the headphone. The audio controller may comprise inputs to enable audio signal to be directly delivered into the audio controller to be processed and delivered to the headphone. The audio controller enables adjusting inputted electrical signal for providing sound via the passive headphone.

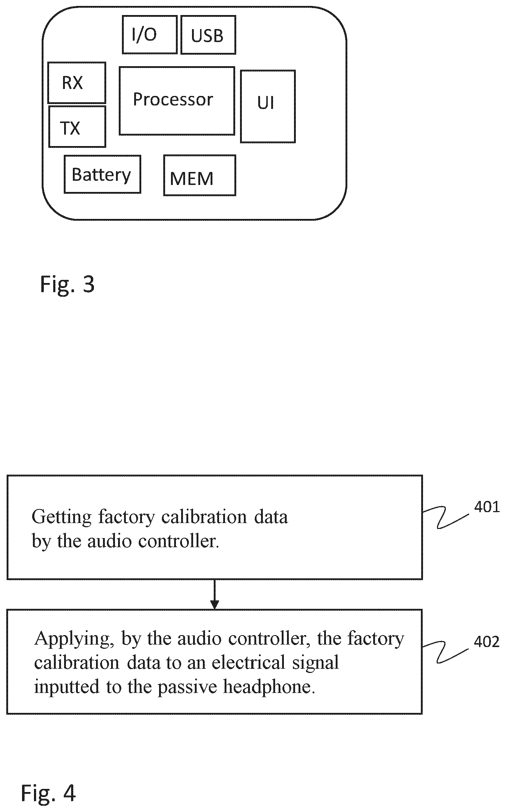

Figure 4 illustrates, by way of an example, a computer. The computer comprises a processor, which may be a central processing unit of the computer. The processor may comprise a microprocessor, a computer processor or an integrated circuit, IC. The computer comprises a memory, MEM. The memory may comprise a non-volatile memory and/or multiple memory units, which may comprise, for example, a read only memory, ROM, a random access memory, RAM, a flash memory. The memory, MEM, may comprise executable instructions, which are executable by the processor. Memory is configured to store information, executable instructions, and/or at least one application configured to communicate with an audio controller. The computer comprises a battery and a user interface. The user interface may comprise input and output means for a user, for example a display, keys, a touch screen. The computer comprises physical ports for wired connections. The ports comprise an input-output, I/O, port, and a universal serial bus, USB, port. The computer may comprise other ports for connecting to external devices and/or terminals. The computer comprises a transmission branch, TX, and a receiving branch, RX. A transmission and receiving branches, TX/RX, may comprise a receiver /a transmitter, a digital-to-analogue converter, an analogue-to-digital converter, an amplifier, and an antenna. The transmission branch, TX, is configured to transmit data and/or signals via a wireless connection. The receiving branch, RX, is configured to receive data and/or signals via a wireless connection. The wireless connection may be a radio frequency network, a cellular network, or a communication network, which may enable exchange of data and information. In addition, the computer may comprise transmission means configured for a short service range wireless communication, like a Bluetooth, an infrared, or alike. The computer may be connected to an internet via a modem, which may be connected via a cable or a wireless connection, like a Wi-Fi according to IEEE 802.11 standard (Institute of Electrical and Electronics Engineers).

Computer may comprise a mobile computer, a mobile device, a handheld computer, a smart phone, a desktop computer, a laptop, a tablet, or any suitable device. The computer may include means for causing getting factory calibration settings in response to a received identifier of the passive headphone, and means for communicating the factory calibration settings to the audio controller. The computer may comprise a software application configured to communicate with the audio controller. The application may provide a user interface for receiving input from the user and for outputting information to the user.

Figure 4 illustrates, by way of an example, a method for calibrating a passive headphone. The passive headphone is connected to an audio controller. The method comprises getting (401), by the audio controller, factory calibration data. The factory calibration data is specific for the passive headphone and associated to an identifier of the passive headphone. The method further comprises applying (402), by the audio controller, the factory calibration data to an electrical signal inputted to the passive headphone. The method may comprise amplifying, by a headphone amplifier integrated to the audio controller, the electrical signal transmitted to one or more transducers of the passive headphone, and reproducing, by the passive headphone, the electrical signal to a sound. The method may comprise pre-storing the factory calibration data to the audio controller paired with the passive headphone and to a remote storage. The method may comprise applying, by the audio controller, factory calibration configured adjust a frequency response of the passive headphone. The method may comprise receiving the factory calibration from a computer. The computer may be configured to access a remote storage in order to receive the factory calibration in response to providing the identifier of the passive headphone. The method may comprise receiving the identifier by the audio controller automatically, in response to being connected to the passive headphone, and/or via a short-range signalling form the passive headphone. The method may comprise receiving the identifier by the computer, via a short-range signalling and/or receiving the identifier from the audio controller by the computer. The method may comprise receiving information on a side of the passive headphone, to which the audio controller is connected to, by the audio controller, automatically, upon connecting the passive headphone to the audio controller, via a connection cable between the audio controller and the passive headphone, and/or via a short-range signalling.

In the previous description and figures a passive headphone is made active by its connection to an audio controller, which is further able to get factory calibration settings for the specific passive headphone via a computer. The system is modular. This enables changing or replacing one of a passive headphone, an audio controller and a computer, at a time. For example, replacement of passive headphone has no effect on other modules of the audio controller and the computer, but the system with the new passive headphone may be connected, calibrated and used with the same accuracy and quality, as with the replaced passive headphone.

A computer may receive a stream or download audio data to be listened via the passive headphone. The audio data is transmitted via the computer to the audio controller. The audio controller is configured process, calibrate and/or equalize audio data. Audio signal processing, or all audio signal processing, is implemented at the audio controller. No further computational or transmission capacity is required from the computer.

A head related transfer function, HRTF, is used to provide a 3-dimensional, 3D, audio experience for a headphone user. The HRTF may use images of a head, body and/or a pinnae of a user in order to form a 3D model of the user. The HRTF describes an acoustic filter quantifying the effect of a shape of a head, body, and pinnae on the sound arriving at the entrance of the ear canal. Reference values for the HRTF may have been prepared using loudspeakers in a listening room, for example. Using HRTFs each passive headphone may be aligned with the predetermined hearing experience, for example of several loudspeakers in a listening room. Thereby, a response of the passive headphone may correspond to an acoustic simulation of a room. The factory calibration settings enable providing quality of passive headphone, at a certain tolerance. A personal HRTF may be utilized after the factory calibration in order to provide personal 3D audio experience. This enables a good quality, user-specific audio experience. Without factory calibration settings, any variations among separate headphones might lead to further variations and/or issues with use of HRTFs.

A listener is able to adjust their headphone. The headphone is factory calibrated in order to produce a natural or flat sound. The play back is predictable. After the factory calibrated natural reproduction, a listener is able to select setting for their headphone. For example, a listener may select so-called warm sound in order to boosts bass frequencies, being low or mid-low frequencies. In warm sound low frequencies dominate over higher frequencies. A warm sound may be called bass-heavy. The opposite of warm sound is so-called bright sound, which boosts high frequencies. In bright sound high frequencies dominate over lower frequencies. For most people audible hearing spectrum ranges from about 20 Hz to 20 kHz, including roughly 20000 different frequencies. In studio environment, full frequency spectrum of different elements, like instruments, may be controlled, adjusted and/or mixed. Frequency response of a signal represents an amount (volume) of every frequency in the human hearing range. The frequency response may be edited in various ways, or example by equalizing and filtering. Equalization is configured to alter parts of a signal frequency response. Filters are configured to attenuate part of the audio spectrum. Audio mixing refers to a process for optimizing and combining multitrack recordings into a final sound product. Mixing may include adjusting and balancing relative levels of separate tracks of multitrack recordings, which may include equalization and compression. The described system comprising an audio controller, a passive headphone and a computer may replace a mixer, which may be called a mixing console, a mixing desk, a mixing board or a software mixer. Mixing may be implemented via a software or application, which has been downloaded or added to the computer, and the audio controller configured to handle the signal processing. While mixing consoles may be large and have an exceptional number of controls, the system presented in this application offers a mobile system for mixing. While number of controls of the described system may not be as excessive as in larger local static mixers, mobility enables instant mixing, despite the place.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

The described features, structures, or characteristics may be combined in any suitable manner in one or more embodiments. In the previous description, numerous specific details are provided, such as examples of structures, lengths, widths, shapes, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

While the forgoing examples are illustrative of the principles of the present invention in one or more particular applications, it will be apparent to those of ordinary skill in the art that numerous modifications in form, usage and details of implementation can be made without the exercise of inventive faculty, and without departing from the principles and concepts of the invention. Accordingly, it is not intended that the invention be limited, except as by the claims set forth below.

The verbs "to comprise" and "to include" are used in this document as open limitations that neither exclude nor require the existence of also un-recited features. The features recited in depending claims are mutually freely combinable unless otherwise explicitly stated. Furthermore, it is to be understood that the use of "a" or "an", i.e. a singular form, throughout this document does not exclude a plurality.

## Claims

1. A system comprising a passive headphone (101) and an audio controller (102), wherein
- the passive headphone (101) is connected to the audio controller (102),
- the audio controller (102) is configured to get factory calibration data, which is specific for the passive headphone (101) and associated to an identifier of the passive headphone (101),
- factory calibration data has been pre-stored to an audio controller paired with the passive headphone (101) and to a remote storage, wherein the pre-stored factory calibration data comprises factory calibration data for both left and right sides of the passive headphone (101),
- in case the identifier of the passive headphone (101) connected to the audio controller is not the one paired with the audio controller, the audio controller is configured to receive the factory calibration via a computer in response to transmittal of the identifier of the passive headphone (101) to the computer; and
- the audio controller (102) is configured to apply the factory calibration data to an electrical signal inputted to the passive headphone (101).

2. A system according to any of the previous claims, wherein factory calibration comprises data determined individually for the headphone and for both sides of the headphone (101).

3. A system according to any of the previous claims, wherein the identifier is dedicated to the passive headphone (101); and/or the identifier is a serial number, a component, a memory chip, a transponder, an electronic tag, or a radio frequency identification, RFID, tag.

4. A system according to any of the previous claims, wherein the identifier is attached to the passive headphone (101), associated with the passive headphone (101), and/or available in or with the passive headphone (101).

5. A system according to any of the previous claims, wherein the audio controller (102) comprises an integrated headphone amplifier and the headphone (101) comprises one or more transducers, wherein the headphone amplifier is configured to amplify the electrical signal transmitted to the one or more transducers of the passive headphone (101) configured to reproduce the electrical signal to a sound output.

6. A system according to any of the previous claims, wherein the audio controller is a mobile or a portable audio controller.

7. A system according to any of the previous claims, wherein the factory calibration comprises at least one of the following parameters measured for both sides of the passive headphone (101): impedance, sensitivity, level and phase of acoustic output in response to an electrical input, optionally for all frequencies.

8. A system according to any of the previous claims, wherein the factory calibration of the passive headphone (101), applied by the audio controller (102), is configured to adjust a frequency response of the passive headphone (101).

9. A system according to any of the previous claims, wherein the computer (103) is configured to be connected to the audio controller (102), wherein the audio controller (102) is configured to receive the factory calibration data from the computer (103), which is configured to access a remote storage (104), in order to receive the factory calibration saved to the remote storage (104), in response to provided identifier of the passive headphone (101).

10. A system according to any of the previous claims, wherein the identifier of the passive headphone (101) is received by the audio controller (102) automatically, in response to the audio controller (102) being connected to the passive headphone (101), and/or via a short-range signalling from the passive headphone (101).

11. A system according to any of the previous claims, wherein the identifier of the passive headphone (101) is inputted to the computer (103), received by the computer (103), received via a short-range signalling by the computer (103), and/or received from the audio controller (102) by the computer (103).

12. A system according to any of the previous claims, wherein information on a side of the passive headphone (101), to which the audio controller (102) is connected to, is received by the audio controller (102) automatically, upon connecting the passive headphone (101) to the audio controller (102), via a connection cable between the passive headphone (101) and the audio controller (102), and/or via short-range signalling.

13. A system according to any of the previous claims, wherein the audio controller (102) is connected to the passive headphone (101) via a wired connection; and/or according to claim 8, wherein the audio controller (102) is connected to the computer (103) via a wired connection.

14. A system according to any of the previous claims, wherein the computer (103) comprises at least a processor and a memory comprising instructions executable by the processor, and wherein the computer (103) is configured to access to a remote storage (104).

15. A method for calibrating a passive headphone, which is connected to an audio controller, the method comprising
- getting (401), by the audio controller, factory calibration data, which is specific for the passive headphone and associated to an identifier of the passive headphone,
- wherein factory calibration data has been pre-stored to an audio controller paired with the passive headphone (101) and to a remote storage, and wherein the pre-stored factory calibration data comprises factory calibration data for both left and right sides of the passive headphone (101),
- in case the identifier of the passive headphone (101) connected to the audio controller is not the one paired with the audio controller, receiving, by the audio controller, the factory calibration via a computer in response to transmitting the identifier of the passive headphone (101) to the computer, and
- applying (402), by the audio controller, the factory calibration data to an electrical signal inputted to the passive headphone.
